# EUROPEAN PATENT APPLICATION

(11) **EP 2 560 283 A1**
(43) Date of publication of application: **20.02.2013**
(21) Application number: 11768784.8
(22) Date of filing: 07.04.2011
(51) Int. Cl.: H03K 17/08, H02M 1/00, H03K 17/695

(54) **SHORT-CIRCUIT PROTECTION METHOD**

(30) Priority: 14.04.2010 JP 2010093530
(71) Applicant: Honda Motor Co., Ltd., Minato-ku Tokyo 107-8556 (JP)
(72) Inventor: HASHIMOTO, Junichi, Wako-shi Saitama 351-0193 (JP); SHINOHARA, Sadao, Wako-shi Saitama 351-0193 (JP)
(74) Representative: Feller, Frank
(86) International application number: PCT/JP2011/058828
(87) International publication number: WO 2011/129263

(57) **Abstract**

A short-circuit protection method for a circuit having a plurality of power switching elements, includes, when a short-circuit of a first power switching element is detected by detection device that detects a short-circuit of the plurality of power switching elements, performing a cut-off process of cutting off a gate of a second power switching element through which a short-circuit current caused by the short-circuit of the first power switching element flows, and changing a resistance value of a gate resistor of the second power switching element while the cut-off process is performed.

## Description

### Technical Field

The present invention relates to a short-circuit protection method using a power switching element or the like.
Priority is claimed on Japanese Patent Application No. 2010-093530, filed April 14, 2010, the content of which is incorporated herein by reference.

### Background Art

In vehicles such as electric vehicles or hybrid vehicles which travel through the driving of a motor, the motor is controlled using an inverter in which power switching elements are bridge-connected to each other. For example, when a short-circuit fault occurs in one of the power switching elements of an upper arm and a lower arm of an inverter, in order to prevent a large short-circuit current from flowing, a short-circuit protection method of cutting off a gate of the other power switching element of the upper arm and the lower arm where a short-circuit fault has not occurred, is known.

In general, the shorter a response time of a power switching element, the greater the rate of current change (di/dt). Therefore, in response to the rate of current change, abnormal voltage (surge voltage) increases. In order to deal with this problem, a power switching element and a snubber circuit that protects a power switching element are provided. However, in order to increase the withstand voltage of a snubber circuit, the size of a used element should increase, which leads to the increase in the size of an inverter. On the other hand, a method of suppressing abnormal voltage by providing a high-resistance gate resistor to alleviate (reduce) the rate of current change during cut-off, has been considered. At this time, a response time during a normal switching operation is delayed. Therefore, in recent years, a method of suppressing excessive abnormal voltage has been proposed in which, in an abnormal state such as a short-circuit failure of a switching element, a gate resistor is switched to have a high resistance to cut off a gate, that is, so-called soft cut-off is performed to alleviate the rate of current change during the gate cut-off (for example, refer to Patent Document 1).

### Citation List

### Patent Document

Patent Document 1: Japanese Unexamined Patent Application, First Publication No. H05-090928

### Summary of Invention

### Technical Problem

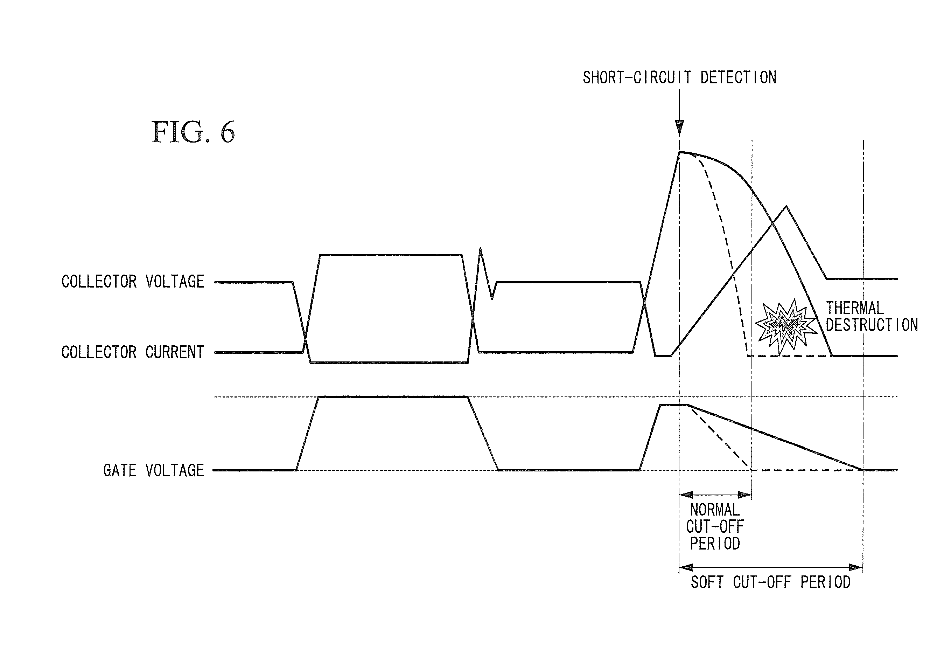

When a gate resistor is switched to have a high resistance, that is, so-called soft cut-off is performed as in the case of the short-circuit protection method of the related art, the change of collector current flowing between a collector and an emitter of a power switching element is alleviated as indicated by a solid line in FIG. 6. As a result, the rise (surge voltage) of abnormal collector voltage can be suppressed. However, in this case, since a time for which collector current flows through a power switching element increases, the power switching element is overheated by short-circuit current. Accordingly, it is necessary that a larger power switching element having heat resistance be used. In FIG. 6, broken lines respectively indicate a collector current and a gate voltage in a case where normal gate cut-off (normal cut-off) using a low-resistance gate resistor is performed.

The present invention has been made in consideration of the above-described circumstances, and an object thereof is to provide a short-circuit protection method capable of cutting off a gate without increasing the size of a power switching element or the like.

### Solution to Problem

In order to solve the above-described problems, the present invention adopts the following aspects.
(1) According to an aspect of the present invention, there is provided a short-circuit protection method for a circuit having a plurality of power switching elements, including, when a short-circuit of a first power switching element is detected by detection means that detects a short-circuit of the plurality of power switching elements, performing a cut-off process of cutting off a gate of a second power switching element through which a short-circuit current caused by the short-circuit of the first power switching element flows; and changing a resistance value of a gate resistor of the second power switching element while the cut-off process is performed.

(2) In the short-circuit protection method, of a circuit according to (1) described above, when a voltage between terminals of the second power switching element, through which the short-circuit current flows, is detected and the voltage between terminals of the second power switching element reaches a predetermined switching voltage, which is set in advance, while the cut-off process is performed, the resistance value of the gate resistor may be changed.

(3) In the short-circuit protection method of a circuit according to (1), when a temperature of the second power switching element is detected and the temperature of the second power switching element reaches a predetermined temperature, which is set in advance, while the cut-off process is performed, the resistance value of the gate resistor may be changed.

### Advantageous Effects of Invention

In the aspect according to (1) described above, when a short-circuit of a first power switching elements is detected, a surge voltage applied to a second power switching element which is not short-circuited increases, and if a cut-off process is performed, a resistance value of a gate resistor of the second power switching element, which is not short-circuited is changed to a direction suppressing the surge voltage. As a result, overvoltage can be prevented from being applied. In this case, the heating of a power switching element can be further suppressed compared to a case where surge voltage is suppressed by a single low resistance value from start to finish of a cut-off process of a gate. Therefore, since withstand current and withstand voltage can be reduced, there is an effect that a gate can be rapidly cut off with a simple circuit configuration without increasing the size of a power switching element or the like.

In the aspect according to (2) described above, in addition to the effect of (1), when a voltage between terminals of the second power switching element is detected and this voltage between terminals reaches a predetermined switching voltage, for example, a gate resistor of the second power switching element is changed from a low resistance value to a high resistance value, which is used when surge voltage is high, to suppress the change of current. As a result, the applying of overvoltage between terminals can be suppressed. Furthermore, the excessive heating of a power switching element can be further suppressed compared to a case of using a single high resistance value from start to finish of the cut-off process.
Accordingly, there is an effect that a gate can be rapidly cut off with a simple circuit configuration without increasing the size of a power switching element or the like.

In the aspect according to (3) described above, in addition to the effect of (1), when a temperature of the second power switching element is detected and this temperature reaches a predetermined switching temperature, for example, a gate resistor is changed to have a low resistance value, which can be used when the heating of a power switching element is large. As a result, the heating of a power switching element can be suppressed. Furthermore, the applying of overvoltage to the second power switching element can be further suppressed compared to a case of using a single low resistance value from start to finish of the cut-off process. Accordingly, a gate can be rapidly cut off with a simple circuit configuration without increasing the size of a power switching element or the like.

### Brief Description of Drawings

FIG. 1 is a circuit diagram illustrating a motor control circuit according to an embodiment of the present invention.
FIG. 2 is a circuit diagram illustrating a gate drive circuit according to the same embodiment.
FIG. 3 is a graph illustrating the change of collector current with respect to collector voltage for each gate voltage of a power switching element according to the same embodiment.
FIG. 4 is a diagram illustrating collector voltage, collector current, gate voltage, and gate resistance when a gate is cut off in the same power switching element.
FIG. 5 is a diagram illustrating collector voltage, collector current, gate voltage, and gate resistance when a gate is cut off in a power switching element according to another embodiment of the present invention.
FIG. 6 is a diagram illustrating collector voltage, collector current, gate voltage, and gate resistance when a gate is cut off in a power switching element of the related art.

### Description of Embodiments

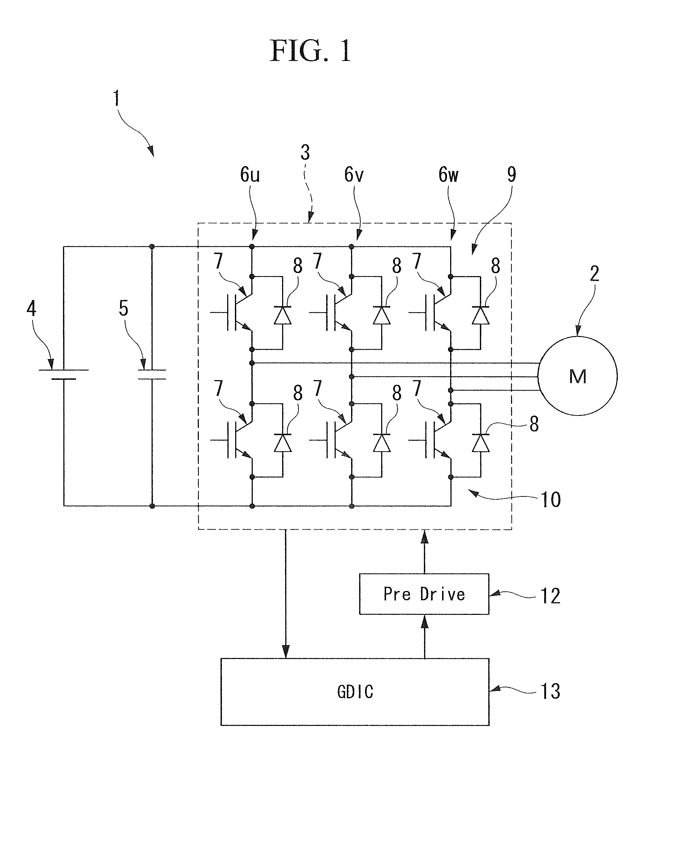

Next, a short-circuit protection method according to an embodiment of the present invention will be described with reference to the drawings. FIG. 1 illustrates a motor control circuit 1 for controlling a motor generator 2 which is mounted to a vehicle, such as a hybrid vehicle, as a drive source along with an internal combustion engine. The motor generator 2 may be a three-phase brushless DC motor. This DC motor includes a rotor (not shown) which has a permanent magnet used for magnetic field, and a stator (not shown) around which respective three-phase coils, which generate rotating magnetic field for rotating the rotor, are wound. An inverter circuit 3 is connected to the motor generator 2. A high-voltage battery 4 is connected to the inverter circuit 3 as a DC power supply and a smoothing capacitor 5 is connected in parallel between the high-voltage battery 4 and the inverter circuit 3.

The inverter circuit 3 is a so-called PWM inverter in which the DC power of the high-voltage battery 4 is applied to the respective coils of the motor generator 2 through pulse-width modulation (PWM) or the like. In this inverter circuit 3, a U-phase arm 6u, a V-phase arm 6v, and a W-phase arm 6w are formed by bridge connection. Hereinafter, the U-phase arm 6u, the V-phase arm 6v, and the W-phase arm 6w are collectively referred to as the respective phase arms 6. The respective phase arms 6 are formed by connecting an upper ann 9 and a lower arm 10 to each other in series, in which the upper arm 9 and the lower arm 10 are respectively formed by connecting power switching elements 7 (for example, an IGBT) and diodes 8 to each other in parallel.

A gate drive IC (GDIC) 13 is connected to the inverter circuit 3 through a pre-drive circuit 12. The gate drive IC 13 outputs gate control signals for controlling the respective power switching elements 7 to be turned on and turned off, to the pre-drive circuit 12.

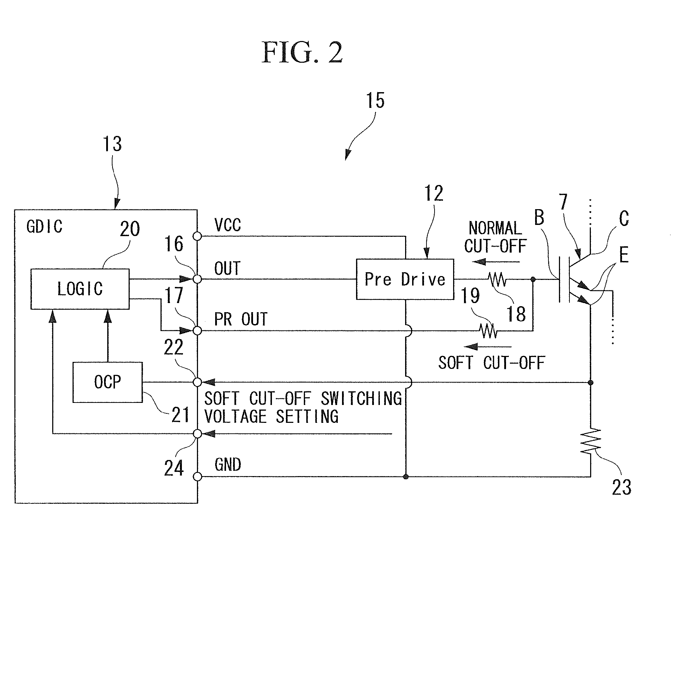

FIG. 2 illustrates a gate drive circuit 15 which drives a gate G of a first power switching element 7 among the respective power switching elements 7 of the above-described inverter circuit 3.

The pre-drive circuit 12 outputs a predetermined voltage for turning on and off the gate G of the power switching element 7 as a gate voltage, based on a gate control signal output from an OUT terminal 16 of the gate drive IC 13. A power supply VCC for driving the pre-drive circuit 12 and a ground GND such as a vehicle body or a case are connected to the pre-drive circuit 12. For example, when the power switching element 7 is an n-channel IGBT and the power switching element 7 is turned off, the pre-drive circuit 12 outputs a ground potential as a gate voltage of the power switching element 7. On the other hand, when the power switching element 7 is turned on, the pre-drive circuit 12 outputs a potential exceeding a predetermined threshold for turning on the gate G of the power switching element 7, for example, outputs a potential of the power supply VCC as a gate voltage of the power switching element 7. Here, the gate voltage represents a voltage applied between the gate G and an emitter E of the power switching element 7. Hereinafter, the turning off of the gate G of the power switching element 7 is referred to as gate cut-off.

A first gate resistor 18 for vibration control is interposed between the pre-drive circuit 12 and the gate G of the power switching element 7. This first gate resistor 18 is a gate resistor which is mainly used for normal switching through pulse-width modulation or the like, and has a relatively low resistance value such that a gate voltage when the power switching element is turned off can be caused to drop instantaneously and a gate voltage when the power switching element is turned on can be caused to rise instantaneously. For example, the resistance value may be approximately from 1 to 10 (Ω).

A second gate resistor 19 is provided between a PR_OUT terminal 17 of the gate drive IC 13 and the gate G of the power switching element 7. The second gate resistor 19 is a gate resistor used when soft cut-off is controlled such that the rate of change (di/dt) of a collector current, which flows through the power switching element 7 during gate cut-off, does not increase. The resistance value of the second gate resistor 19 is set to be higher than that of the first gate resistor 18 (for example, approximately from 10 to 100 (Ω)). In the soft cut-off, the gate voltage of the power switching element 7 drops more slowly compared to the case of the above-described normal switching and thus the gate G is slowly cut off.

The gate drive IC 13 includes a logic circuit (LOGIC) 20 which performs various controls and an OCP (Over Current Protection) circuit 21 which detects a short-circuit of the power switching elements 7.

The OCP circuit 21 individually monitors currents flowing through the respective power switching elements 7 of the above-described respective phase arms 6 and determines whether an overcurrent flows therethrough or not. A terminal voltage of a shunt resistor 23, which is connected in series between the emitter of the power switching element 7 and the GND through an OC input terminal 22 of the gate drive IC 13, is input to the OCP circuit 21. In addition, in the OCP circuit 21, a predetermined threshold voltage for detecting a short-circuit current is set in advance, and the OCP circuit 21 determines whether the terminal voltage of the shunt resistor 23 reaches the predetermined threshold voltage or not. The OCP circuit 21 determines that overcurrent flows when the terminal voltage of the shunt resistor 23 reaches the predetermined threshold voltage. In addition, when it is determined that overcurrent flows, the OCP circuit 21 detects the occurrence of a short-circuit fault of the power switching element 7 through which overcurrent flows and outputs the detection result to the logic circuit 20. Not all but a portion of emitter current of the power switching element 7 is divided and flows through the shunt resistor 23.

The logic circuit 20 controls the power switching element 7 to be turned on and turned off through the pre-drive circuit 12. Specifically, the logic circuit 20 outputs pre-drive control signals for controlling the pre-drive circuit 12 through the OUT terminal 16 provided in the gate drive IC 13. In addition, in order to perform control through pulse-width modulation, a motor drive current is fed back from a current sensor not shown and input to the logic circuit 20.

The logic circuit 20 directly controls the gate of the power switching element 7 to be cut off without the pre-drive circuit 12. The direct gate cut-off using this logic circuit 20 is the above-described soft cut-off and is performed by outputting a predetermined voltage from the PR_OUT terminal 17 provided in the gate drive IC 13. When the soft cut-off is performed, a voltage (for example, the ground voltage) lower than a threshold for turning on the power switching element 7 may be output from the PR_OUT terminal 17. Here, when the normal switching control is performed, the PR_OUT terminal 17 is set to a high impedance state so as not to affect a gate voltage output from the pre-drive circuit 12.

When it is detected that a short-circuit fault occurs in one (first power switching element) of the power switching elements 7 of the upper arm 9 and the lower arm 10, the logic circuit 20 starts a process (gate cut-off process) of cutting off the gate G of the other power switching element 7 (second power switching element) for short-circuit protection.

Once the gate cut-off process is started, the logic circuit 20 changes a gate resistor during the gate cut-off process. Accordingly, a resistance value of the gate resistor is changed. More specifically, the normal gate cut-off which is performed by the pre-drive circuit 12 through the first gate resistor 18 is switched to the soft cut-off which is performed by the gate drive IC 13 through the second gate resistor 19.

A voltage sensor (not shown) provided in the power switching element 7 detects a terminal voltage between the emitter and the collector of the power switching element 7 (hereinafter, simply referred to as the collector voltage) and the collector voltage is input to the logic circuit 20. The logic circuit 20 can set a soft cut-off switching voltage through a voltage setting terminal 24 provided in the gate drive IC 13.
The soft cut-off switching voltage is a threshold for the collector voltage and an arbitrary voltage value not exceeding the withstand voltage of the power switching element 7 is set in advance as the soft cut-off switching voltage. When the collector voltage reaches the soft cut-off switching voltage during the gate cut-off process, the logic circuit 20 switches the cut-off from the normal gate cut-off to the soft cut-off. In addition, when it is detected that the gate voltage output from the pre-drive circuit 12 reaches the ground potential, the logic circuit 20 finishes the gate cut-off process.

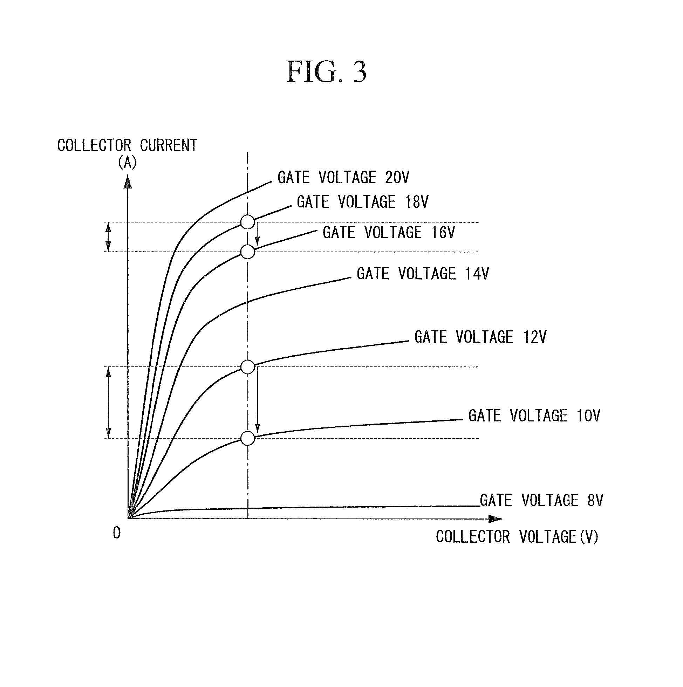

Here, in FIG. 3, the vertical axis represents the collector current (A) and the horizontal axis represents the collector voltage (V). FIG. 3 illustrates the change of the collector current with respect to the collector voltage for each of different gate voltages. According to this graph, for example, under a condition of a constant collector voltage (indicated by a chain line in the vertical direction), the amount of the collector current which drops when the gate voltage drops from 12 V to 10 V is larger than the amount of the collector current which drops when the gate voltage drops from 18 V to 16 V. That is, in a region where the gate voltage is high, the amount of the collector current dropping in response to the drop of the gate voltage is relatively smaller, and in a region where the gate voltage is low, the amount of the collector current dropping in response to the drop of the gate voltage is relatively large.

Briefly, in the initial stage of the gate cut-off process, the gate voltage is high; therefore, even when the gate voltage drops rapidly, the rise of the collector voltage is small. In the terminal stage of the gate cut-off process, the gate voltage is low, therefore, when the gate voltage drops rapidly in the same manner as that of the initial stage of the gate cut-off process, the rise of the collector voltage is large.

Therefore, when the collector voltage is lower than or equal to the soft cut-off switching voltage, the logic circuit 20 performs the normal gate cut-off in which the first gate resistor 18 having a relatively lower resistance is set as the gate resistor, so as to drop the gate voltage rapidly. On the other hand, when the collector voltage reaches the soft cut-off switching voltage, the logic circuit 20 performs a gate resistor switching control of switching the cut off to the soft cut-off in which the second gate resistor 19 is set as the gate resistor, so as to drop the gate voltage slowly.

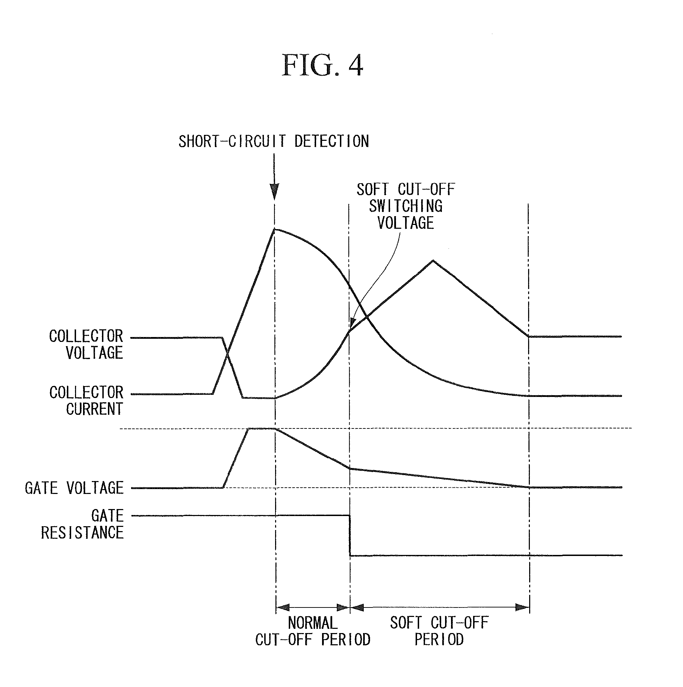

That is, according to the above-described first embodiment, as shown in FIG. 4, when overcurrent (short-circuit) is detected in one of the power switching elements 7 of the upper arm 9 and the lower arm 10, the logic circuit 20 starts the gate cut-off process (cut-off process) of cutting off the gate of the other power switching element of the upper arm 9 and the lower arm 10, and starts the normal gate cut-off using the first gate resistor 18 and compares the collector voltage and the soft cut-off switching voltage to each other. As a result of the comparison, when the collector voltage does not reach the soft cut-off switching voltage, the normal cut-off using the first gate resistor 18 is continued, and when the collector voltage reaches soft cut-off switching voltage, the cut-off is switched to the soft cut-off using the second gate resistor 19.

Accordingly, in a case where it is detected that a short-circuit fault occurs in one of the power switching elements 7, the resistance value of the gate resistor can be changed while the gate cut-off process is performed in the other power switching element 7. Therefore, when the collector voltage rises, the gate resistance value is switched to a direction suppressing the rise of the collector voltage, that is, the gate resistor is switched to the second gate resistor 19 having a high resistance value to reduce the rate of current change of the collector current; and as a result, overvoltage is prevented from being applied. Furthermore, in this case, a time for which the gate resistance value is set to a high resistance value is shorter than that of a case where the gate resistance value is set to a high resistance value from start to finish of the cut-off process of the gate G. As a result, rapid gate cut-off is possible and the heating of the power switching element 7 can be suppressed. Accordingly, withstand current and withstand voltage can be designed to be small and the increase in the size of the power switching element 7 or the like can be prevented.

Furthermore, when a collector voltage is detected and it is determined that the collector voltage reaches the soft cut-off switching voltage, it is determined that the collector voltage rises. The first gate resistor 18 used in the normal state is changed to the second gate resistor 19 used for only the case where the collector voltage is high to suppress the rate of current change. As a result, the rise of the collector voltage due to surge voltage can be suppressed. In addition, a time for which the gate resistor is set to the second gate resistor 19 having a high resistance value is shortened and thus the excessive heating of the power switching element 7 can be suppressed. As a result, the gate G can be rapidly cut off with a simple circuit configuration without increasing the size of the power switching element 7 or the like.

Next, a short-circuit protection method according to a second embodiment of the present invention will be described. In the above-described first embodiment, when the gate cut-off process starts and the collector voltage reaches the soft cut-off switching voltage, the normal gate cut-off is switched to the soft cut-off. The second embodiment has the same circuit configuration except for a difference in that the resistance value of the gate resistor is changed based on the temperature of the power switching element 7. The same components as those of the first embodiment are represented by the same reference numerals and the repetitive description will be omitted.

A temperature sensor (not shown) that measures the temperature of the power switching element 7 is connected to the gate drive IC 13. This temperature sensor inputs a temperature signal to the logic circuit 20 as the temperature of the power switching element 7. In the logic circuit 20, a threshold temperature for switching the gate resistor is set in advance instead of the above-described soft cut-off switching voltage and temperature signals are input from the temperature sensor to the logic circuit 20.

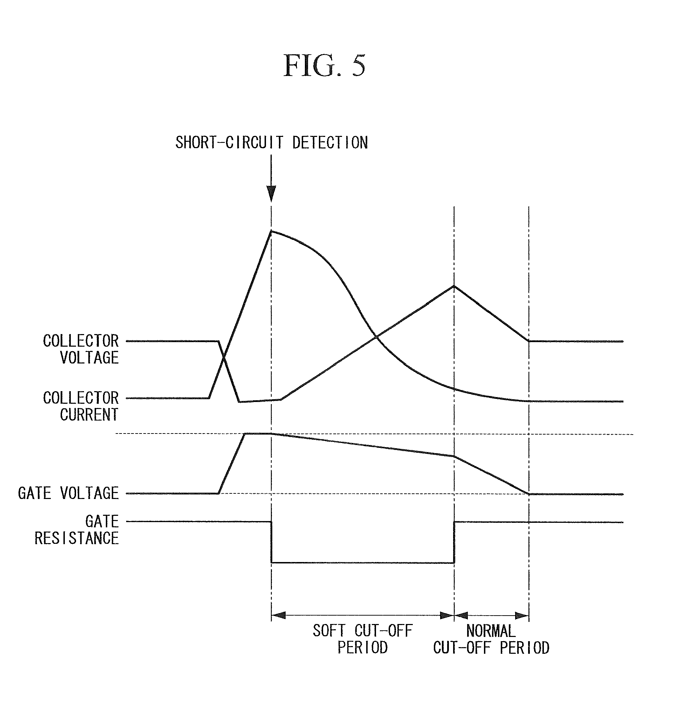

As shown in FIG. 5, when the OCP circuit 21 detects overcurrent (short-circuit) in a power switching element 7 of one of the upper arm 9 and the lower arm 10, the gate cut-off process is started in a power switching element 7 of the other arm and the soft cut-off using the second gate resistor 19 is performed. Furthermore, the temperature sensor determines whether the temperature of the power switching element 7 reaches the threshold temperature or not. The temperature of the power switching element 7 changes in proportion to the integrated value of the collector current. Therefore, when it is determined that measurement results which are obtained by the temperature sensor from start to finish of the gate cut-off process reach the threshold temperature, the logic circuit 20 performs a control in which the soft cut-off using the second gate resistor 19 having a high resistance value is switched to the first gate resistor 18 having a low resistance value. As a result, the collector current can drop rapidly.

Therefore, according to the second embodiment, when the temperature of the power switching element 7 is detected and this temperature reaches a predetermined threshold temperature, it is determined that the heating of the power switching element 7 is large and the gate resistor is switched from the second gate resistor 19 having a high resistance value to the first gate resistor 18 having a low resistance value. Accordingly, the collector current can drop rapidly and the heating can be suppressed. As a result, as compared to a case where only a single gate resistor having low resistance value is continuously used from start to finish of the gate cut-off process, a time for which only a low resistance value is used can be reduced and thus surge voltage can be suppressed. As a result, the increase in the size of the power switching element 7 or the like can be prevented and the gate G can be rapidly cut off with a simple circuit configuration.

In the above-described short-circuit protection methods according to the respective embodiments, a circuit in which an IGBT is used as the power switching element 7 has been described as an example. However, the power switching element 7 is not limited to IGBT, and for example, switching elements such as a bipolar transistor and a MOS-FET (filed-effect transistor) may be used. When an FET is used instead of an IGBT, in the above description according to the exemplary embodiments, the collector voltage and the collector current only needs to be replaced with the drain voltage and the drain current, respectively.

In addition, the n-channel power switching element has been described as an example. However, the same configuration shall be applied to an inverter circuit using a p-channel power switching element. In this case, high and low of the gate voltage, which is output from the above-described gate drive IC according to the respective embodiments, only need to be inverted.

In addition, in the above-described embodiments, a case where switching between the first gate resistor 18 and the second gate resistor 19 is performed based on the collector voltage or the temperature of the power switching element 7, has been described. However, the resistance value of the gate resistor may be switched using both of the collector voltage and the temperature of the power switching element 7. In this case, for example, a configuration may be adopted in which, when the collector voltage reaches the soft cut-off switching voltage, the normal gate cut-off is switched to the soft cut-off, and when the temperature of the power switching element 7 reaches a predetermined threshold temperature, the soft cut-off is switched to the normal gate cut-off.

Furthermore, in the above-described first embodiment, a case has been described where when the collector voltage reaches the soft cut-out switching voltage, the first gate resistor 18 (normal gate cut-off) is switched to the second gate resistor 19 (soft cut-off), and when the temperature of the power switching element 7 reaches the threshold temperature, the second gate resistor 19 is switched to the first gate resistor 18. However, the order of the soft cut-off and the normal cut-off may be reversed. In this case, depending on the characteristics of the power switching element 7 (for example, an IGBT), the heating of the power switching element 7 and the applying of overvoltage can be suppressed more efficiently.

In addition, in the above-described first embodiment, a case where the resistance value of the gate resistor is changed based on the collector voltage of the power switching element 7, has been described. Furthermore, in the above-described second embodiment, a case where the resistance value of the gate resistor is changed based on the temperature of the power switching element 7, has been described. However, the collector voltage and the temperature of the power switching element 7 rise over time, respectively and a short-circuit current flowing through the power switching element 7 can be estimated in advance. Therefore, a predetermined time for switching the gate resistor may be set in advance and the gate resistor may be switched after a predetermined time from the start of the gate cut-off process.

### Industrial Applicability

A short-circuit protection method capable of cutting off a gate without increasing the size of a power switching element or the like can be provided.

### Reference Signs List

- 7:: power switching element
- 18:: first gate resistor
- 19:: second gate resistor
- 21:: OCP circuit (detection means)
- G:: gate

## Claims

1. A short-circuit protection method for a circuit having a plurality of power switching elements, the method comprising:
when a short-circuit of a first power switching element is detected by detection device that detects a short-circuit of the plurality of power switching elements,
performing a cut-off process of cutting off a gate of a second power switching element through which a short-circuit current caused by the short-circuit of the first power switching element flows; and
changing a resistance value of a gate resistor of the second power switching element while the cut-off process is performed.

2. The short-circuit protection method according to claim 1, further comprising: when a voltage between terminals of the second power switching element, through which the short-circuit current flows, is detected and the voltage between terminals of the second power switching element reaches a predetermined switching voltage, which is set in advance, while the cut-off process is performed,
changing the resistance value of the gate resistor.

3. The short-circuit protection method according to claim 1, further comprising: when a temperature of the second power switching element is detected and the temperature of the second power switching element reaches a predetermined temperature, which is set in advance, while the cut-off process is performed,
changing the resistance value of the gate resistor.
